# EUROPEAN PATENT APPLICATION

(11) **EP 0 788 234 A2**
(43) Date of publication of application: **06.08.1997**
(21) Application number: 97101365.1
(22) Date of filing: 29.01.1997
(51) Int. Cl.: H03K 19/0185, H03K 19/0948

(54) **ECL to MOS level conversion circuit using CMOS technologies**

(30) Priority: 31.01.1996 JP 15007/96
(71) Applicant: NEC CORPORATION, Tokyo (JP)
(72) Inventor: Kurisu, Masakazu, Minato-ku, Tokyo (JP)
(74) Representative: Glawe, Delfs, Moll & Partner

(57) **Abstract**

In a level conversion circuit powered by first and second power supply terminals (GND, V_{SS}), a MOS differential amplifier (1) receives first and second input voltages (Vᵢₙ₁, Vᵢₙ₂) to generate first and second complementary output voltages (V₁, V₂) in response to a difference between the first and second input voltages. A MOS inverter (2) receives the second complementary output voltage to generate an inverted voltage of the second complementary output voltage. A MOS push-pull output circuit (3) receives the first complementary output voltage and the inverted voltage to generate an output voltage (Vₒᵤₜ) in response to said the complementary output voltage and the inverted voltage.

## Description

### BACKGROUND OF THE INVENTION

### Field of the Invention

The present invention relates to a level conversion circuit for converting an emitter coupled logic (ECL) level signal into a complementary metal oxide semiconductor (CMOS) leve signal.

### Description of the Related Art

As a result of the technological advancement of producing finer and smaller CMOS devices, CMOS circuits operable in a gigaherz band are currently being realized. ECL interface circuits have been popularly used as means for transmitting high frequency signals with low reflectivity because of their excellent impedance matching properties. Thus, it is a matter of urgent necessity to realize an ECL interface adapted to operate in a gigaherz band, using the CMOS technology. Therefore, the present invention relates to a level conversion circuit adapted to high frequency signals in a gigaherz band and realized by means of the CMOS technology.

A first prior art level conversion circuit includes a BiMOS differential amplifier, a CMOS inverter and a CMOS push-pull output circuit (see JP-A-62-159516). This will be explained later in detail.

In the first prior art level conversion circuit, however, since bipolar transistors are included therein, it is impossible to manufacture the level conversion circuit by using only CMOS technologies. In addition, since use is made of two power supply voltages, it is impossible to adopt a singe power supply voltage system.

A second prior art level conversion circuit includes a source follower circuit and a CMOS push-pull output circuit (see JP-A-3-74927). This also will be explained later in detail.

In the second prior art level conversion circuit, since no bipolar transistors are included therein, it is possible to manufacture the level conversion circuit by using only CMOS technologies. In addition, since use is made of only one power supply voltage, it is possible to adopt a single power supply voltage system.

In the second prior art level conversion circuit, however, since a single ended input system is adopted, i.e., a reference voltage is not used, a logic threshold value of the circuit and the duty ratio of the output voltage are affected by the manufacturing fluctuation of the MOS transistors such as the fluctuation of the threshold voltage thereof.

### SUMMARY OF THE INVENTION

It is an object of the present invention to provide an ECL to CMOS level conversion circuit capable of being manufactured by the CMOS technologies.

Another object is to adopt a single power supply voltage system for the ECL to CMOS level conversion circuit.

Still another object is to suppress the fluctuation of a logic threshold value and a duty ratio of an output voltage caused by manufacturing fluctuations.

According to the present invention, in a level conversion circuit powered by first and second power supply terminals, a MOS differential amplifier receives first and second input voltages to generate first and second complentary output voltages in response to a difference between the first and second input voltages. A MOS inverter receives the second complementary output voltage to generate an inverted voltage of the second complementary output voltage. A MOS push-pull output circuit receives the first complementary output voltage and the inverted voltage to generate an output voltage in response to the complementary output voltage and the inverted voltage.

### BRIEF DESCRIPTION OF THE DRAWINGS

The present invention will be more clearly understood from the description as sat forth below, as compared with the prior art, with reference to the accompanying drawings, wherein:
Fig. 1 is a circuit diagram illustrating a first prior art level conversion circuit;
Fig. 2 is a circuit diagram illustrating a second prior art level conversion circuit;
Fig. 3 is a circuit diagram illustrating a first embodiment of the level conversion circuit according to the present invention;
Fig. 4 is a circuit diagram of the constant current source of Fig. 3;
Fig. 5 is a circuit diagram illustrating a second embodiment of the level conversion circuit according to the present invention; and
Figs. 6 and 7 are circuit diagrams illustrating modifications of the circuit of Fig. 3.

### DESCRIPTION OF THE PREFERRED EMBODIMENTS

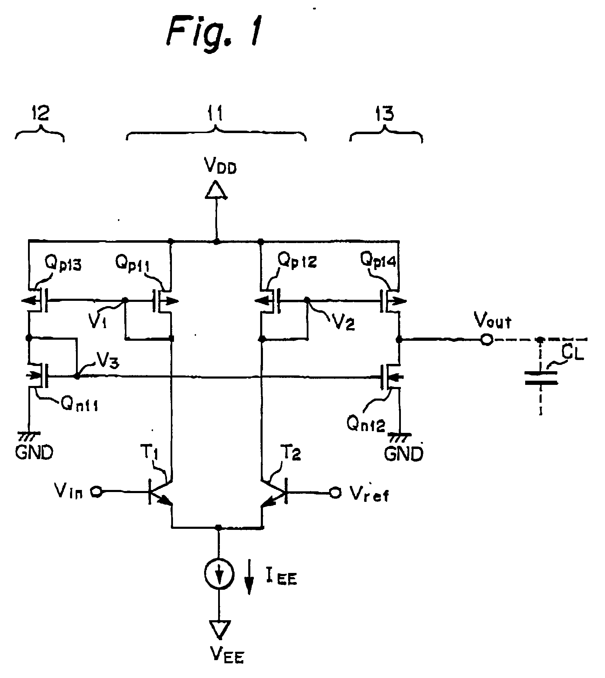

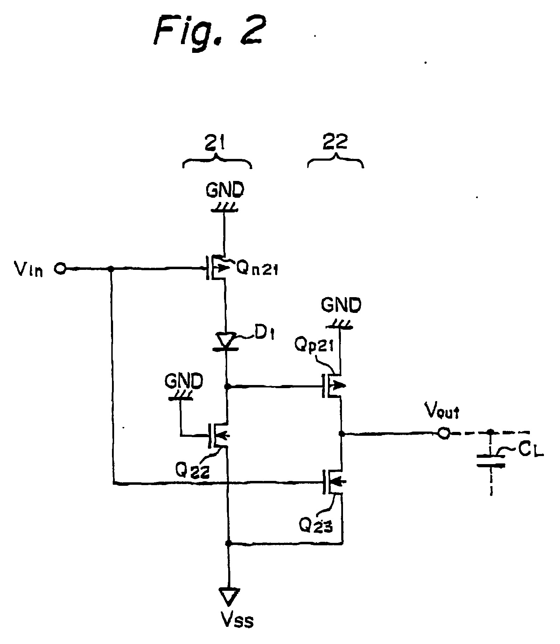

Before the description of the preferred embodiments, prior art level conversion circuits will be explained with reference to Figs. 1 and 2.

In Fig. 1, which illustrates a first prior art level conversion circuit (see-JP-A-62-159516), reference numeral 11 designates a differential amplifier, 12 designates an inverter, and 13 designates a push-pull output circuit. Also, references V_{DD}, GND and V_{EE} designate power supply voltage terminals whose voltages are, for example, 3.3 V, 0 V and -5.2 V, respectively.

The differential amplifier 11 includes NPN-type bipolar transistors T₁ and T₂ having emitters connected to a constant current source I_{EE}, and P-channel MOS transistors Qₚ₁₁ and Qₚ₁₂. In this case, an ECL level input voltage Vᵢₙ is applied to a base of the bipolar transistor T₁, and a reference voltage V_{ref} is applied to a base of the bipolar transistor T₂. Note that the input voltage Vᵢₙ is swung from -0.9 V to -1.7 V, for example.

The inverter 12 includes a P-channel MOS transistor Qₚ₁₃ and an N-channel MOS transistor Qₙ₁₁. The inverter 12 is operated by an output voltage V₁ of the differential amplifier 11. In this case, the MOS transistors Qₚ₁₁ and Qₚ₁₃ form a current mirror circuit.

The push-pull output circuit 13 includes a P-channel MOS transistor Qₚ₁₄ controlled by an output voltage V₂ of the differential amplifier 11 and an N-channel MOS transistor Qₙ₁₂ controlled by an output voltage V₃ of the inverter 12. In this case, the MOS transistors Q_{F12} and Qₚ₁₄ form a current mirror circuit, and the MOS transistors Qₙ₁₁ and Qₙ₁₂ also form a current mirror circuit.

In the level conversion circuit of Fig. 1, when the input voltage Vᵢₙ is higher than the reference voltage V_{ref}, the bipolar transistors T₁ and T₂ are turned ON and OFF, respectively, so that the collector voltage of the bipolar transistor T₁ is lowered. Therefore, the transistors Qₚ₁₁ and Qₚ₁₃ are both turned ON, and accordingly, the transistors Qₙ₁₁ and Qₙ₁₂ are both turned ON. On the other hand, since the collector voltage of the bipolar transistor T₂ is raised to a level close to V_{DD}, the transistors Qₚ₁₂ and Qₚ₁₄ are both turned OFF. Thus, a load capacity indicated by C_{L} is discharged by the transistor Qₙ₁₂, so that an output voltage Vₒᵤₜ is reduced to GND.

Also, in the circuit of Fig. 1, when the input voltage Vᵢₙ is lower than the reference voltage V_{ref}, the bipolar transistors T₁ and T₂ are turned OFF and ON, respectively, so that the collector voltage of the bipolar transistor T₂ is lowered. Therefore, the transistors Qₚ₁₂ and Qₚ₁₄ are both turned ON. On the other hand, since the collector voltage of the bipolar transistor T₁ is raised to a level close to V_{DD}, the transistors Qₚ₁₁ and Qₚ₁₃ are both turned OFF, and accordingly, the transistors Qₙ₁₁ and Qₙ₁₂ are both turned OFF. Thus, the load capacity indicated by C_{L} is charged by the transistor Qₚ₁₄, so that the output voltage Vₒᵤₜ is raised to V_{DD}.

Thus, in the level conversion circuit of Fig. 1, a full swing between GND and V_{DD} can be obtained at the output voltage Vₒᵤₜ.

In the level conversion circuit of Fig. 1, however, since the bipolar transistors T₁ and T₂ are included therein, it is impossible to manufacture the level conversion circuit of Fig. 1 by using only CMOS technologies In addition, since use is made of two power supply voltages V_{DD} and V_{EE}, it is impossible to adopt a single power supply voltage system.

In Fig. 2, which illustrates a second prior art level conversion circuit (see-JP-A-3-74927), reference numeral 21 designates a source follower circuit, and 22 designates a push-pull output circuit. Also, references GND and V_{SS} designate power supply voltage terminals whose voltages are, for example, 0V and -3.3V, respectively.

The source follower circuit 11 includes an N-channel MOS transistor Qₙ₂₁, a diode D₁ and an N-channel MOS transistor Qₙ₂₂. An ECL level input voltage Vᵢₙ is applied to a gate of the transistor Qₙ₂₁.

The push-pull output circuit 22 includes a P-channel MOS transistor Qₚ₂₁ controlled by an output voltage of the source follower circuit 21 and an N-channel MOS transistor Qₙ₂₃ controlled by the input voltage Vᵢₙ.

In the level conversion circuit of Fig. 2, when the input voltage Vᵢₙ is high, the source voltage of the transistor Qₙ₂₁ is raised, and accordingly, the cathode voltage of the diode D₁ is raised. As a result, the transistor Qₚ₂₁ is turned OFF. On the other hand, the transistor Qₙ₂₃ is turned On by the input voltage Vᵢₙ. Thus, a load capacity indicated by C_{L} is discharged by the transistor Qₙ₂₃.

Also, in the level conversion circuit of Fig. 2, when the input voltage Vᵢₙ is low, the source voltage of the transistor Qₙ₂₁ is lowered, and accordingly, the cathode voltage of the diode D₁ is lowered. As a result, the transistor Qₚ₂₁ is turned ON. On the other hand, the transistor Qₙ₂₃ is turned OFF by the input voltage Vᵢₙ. Thus, the load capacity indicated by C_{L} is charged by the transistor Qₚ₂₁.

Thus, in the level conversion circuit of Fig. 2, a full swing between GND and V_{SS} can be obtained at the output voltage Vₒᵤₜ.

In the level conversion circuit of Fig. 2, since no bipolar transistors are included therein, it is possible to manufacture the level conversion circuit of Fig. 2 by using only CMOS technologies. In addition, since use is made of one power supply voltage V_{SS}, it is possible to adopt a single power supply voltage system.

In the level conversion circuit of Fig. 2, however, sisnce a single ended input system is adopted, i.e., a reference voltage is not used, a logic threshold value of the circuit and the duty ratio of the output voltage vₒᵤₜ are affected by the manufacturing fluctuations of the MOS transistors such as the fluctuation of the threshold voltage thereof.

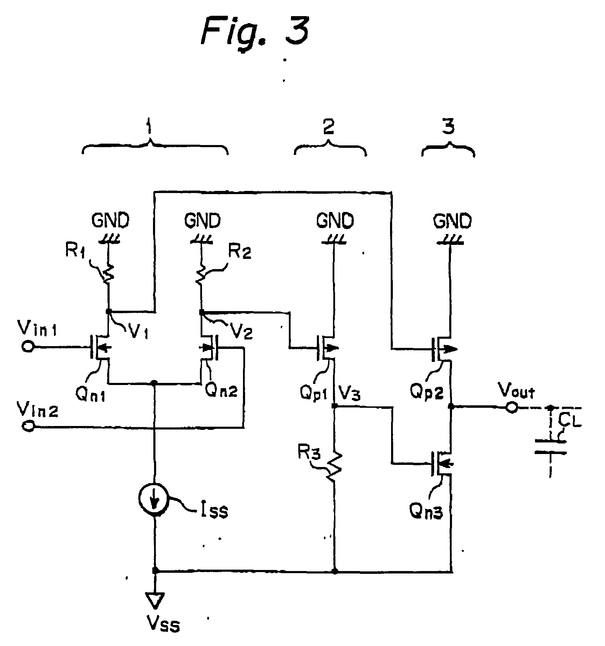

In Fig. 3, which illustrates an embodiment of the present invention, reference numeral 1 designates a differential amplifier, 2 designates an inverter, and 3 designates a push-pull output circuit.

The differential amplifier 1 includes N-channel MOS transistors Qₙ₁ and Qₙ₂ having sources connected to a constant current source I_{SS}, and resistors R₁ and R₂ connected between drains of the transistors Qₙ₁ and Qₙ₂ and the power supply voltage terminal GND. In this case, an ECL level input voltage Vᵢₙ₁ is applied to a gate of the transistor Qₙ₁, and another ECL level input voltage Vᵢₙ₂ is applied to a gate of the transistor Qₙ₂.

The inverter 2 includes a P-channel MOS transistor Qₚ₁ and a resistor R₃. The inverter 2 is operated by an output voltage V₂ of the differential amplifier 1.

The push-pull output circuit 3 includes a P-channel MOS transistor Qₚ₂ controlled by an output voltage V₁ of the differential amplifier 1 and an N-channel MOS transistor Qₙ₃ controlled by an output voltage V₃ of the inverter 2.

In the level conversion circuit of Fig. 3, when the input voltage Vᵢₙ₁ is lower than the input voltage Vᵢₙ₂, the transistors Qₙ₁ and Qₙ₂ are turned OFF and ON, respectively, so that the drain voltages of the transistors Qₙ₁ and Qₙ₂ are raised and lowered respectively. Therefore, the output voltage V₃ of the inverter 2 is raised. As a result, the transistors Qₚ₂ and Qₙ₃ are turned OFF and ON, respectively. Thus, a load capacity indicated by C_{L} is discharged by the transistor Qₙ₃, so that an output voltage Vₒᵤₜ is reduced to V_{SS}.

Also, in the level conversion circuit of Fig. 3, when the input voltage Vᵢₙ₁ is higher than the input voltage Vᵢₙ₂, the transistors Qₙ₁ and Qₙ₂ are turned ON and OFF, respectively, so that the drain voltages of the transistors Qₙ₁ and Qₙ₂ are lowered and raised respectively. Therefore, the output voltage V₃ of the inverter 2 is lowered. As a result, the transistors Qₚ₂ and Qₙ₃ are turned ON and OFF, respectively. Thus, the load capacity indicated by C_{L} is charged by the transistor Qₚ₂, so that the output voltage Vₒᵤₜ is raised to GND.

Thus, in the level conversion circuit of Fig. 3, a full swing between GND and V_{SS} can be obtained at the output voltage Vₒᵤₜ.

In the level conversion circuit of Fig. 3, since no bipolar transistors are included therein, it is possible to manufacture the level conversion circuit of Fig. 3 by using only CMOS technologies. In addition, since use is made of only one power supply voltages V_{SS}, it is possible to adopt a single power supply voltage system. Further, since two ECL input voltages are used, a logic threshold value of the circuit and the duty ratio of the output voltage Vₒᵤₜ are hardly affected by the manufacturing fluctuations of the MOS transistors such as the fluctuation of the threshold voltage thereof.

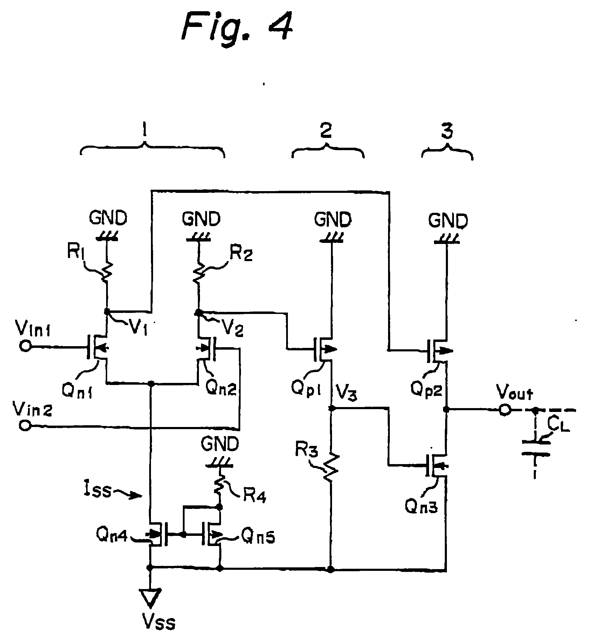

The constant current source I_{SS} is illustrated in detail in Fig. 4. That is, the constant current source I_{SS} includes two N-channel MOS transistors Qₙ₄ and Qₙ₅ forming a current mirror circuit, and a resistor R₄. In this case, since a voltage V₄ at a node between the resistor R₄ and the transistor Qₙ₅ dependeds on the fluctuation of the threshold voltage of the MOS transistors, a current flowing through the transistor Qₙ₅ , i.e., the current I_{SS} flowing through the transistor Qₙ₄ is almost constant. Additionally, there is an advantage that the amplitude of the output voltage Vₒᵤₜ is held substantially to a constant level regardless of fluctuations in the resistance if the resistor R₄ is manufactured by a process identical to that of the resistors R₁ and R₂ of the differential amplifier. For instance, the currents flowing through the resistors R₄ and R₅ are reduced but the reduction is offset by an increase in the resistances of the resistors R₁ and R₂ so that the amplitude of the output voltage Vₒᵤₜ does not change significantly if the real value of the resistance is higher than its designed value. The amplitude of the output voltage Vₒᵤₜ does not change either if the real value of the resistance is lower than the designed value for the same reason.

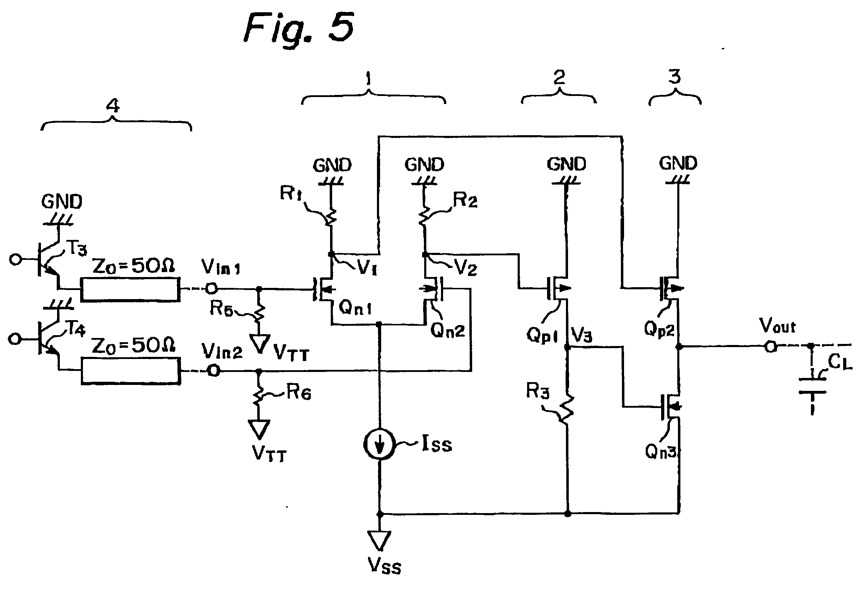

In Fig. 5, which illustrates a second embodiment of the present invention, resistors R₅ and R₆ are connected to gates of the transistors Qₙ₁ and Q ₙ₂, respectively, and are connected to a power supply voltage terminal V_{TT} whose voltage is -2.0 V, for example. That is, generally, the input voltages Vᵢₙ₁ and Vᵢₙ₂ are generated by an ECL interface 4 which includes emitter followers T₃ and T₄ and transmission paths whose characteristic impedance Z_{O} is normally about 50 Ω.

If the resistances of the resistors R₅ and R₆ are made to agree with the characteristic impedances Z_{O} of the transmission paths, the reflection attributable to inconsistent impedances can be effectively suppressed to ensure an excellent signal transmission effect. Thus, a high speed conversion can be realized from ECL to MOS without introducing any power supply voltage in addition to the power supply voltage terminal V_{TT} to be used at the ECL interface 4.

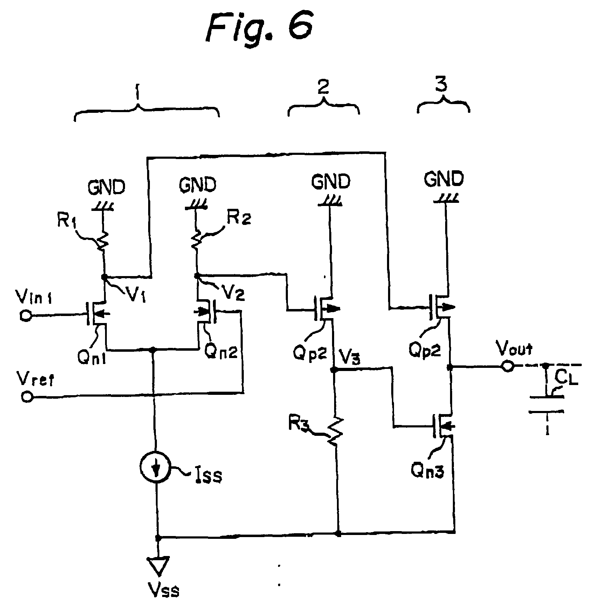

In Fig. 6, which illustrates a modification of the circuit of Fig. 3, a reference voltage V_{ref} of the ECL interface is used instead of the input voltage Vᵢₙ₂ to form a non-inversion type level conversion circuit with a single ended input using the input voltage Vᵢₙ₁.

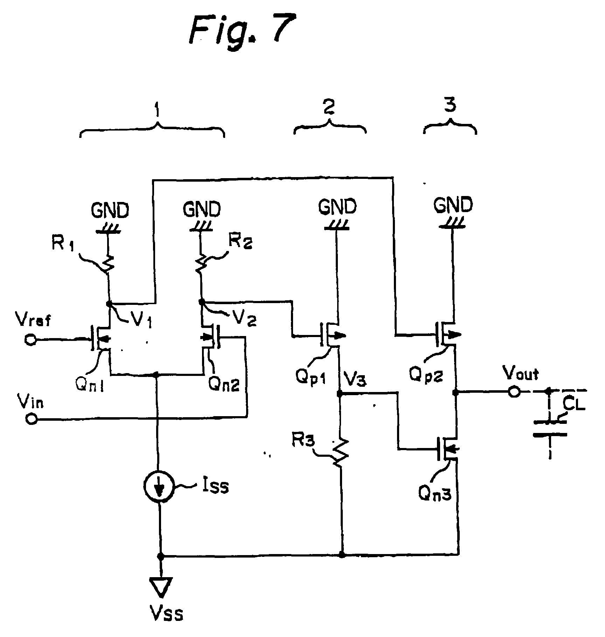

In Fig. 7, which illustrates another modification of the circuit of Fig. 3, a reference voltage V_{ref} of the ECL interface is used instead of the input voltage Vᵢₙ₁ to form an inversion type level conversion circuit with a single ended input using the input voltage Vᵢₙ₂.

While the circuits of Figs. 6 and 7 are not comparable with the differential input type circuits of Figs. 3, 4, and 5 in terms of high speed operation and adaptability to the deviation in performance, the circuits of Figs. 6 and 7 have an advantage that the number of signal pins can be reduced.

In the above-described embodiments, other loads such as gate-drain connected enhancement type MOS transistors and gate-source connected depletion type MOS transistors can be used instead of the resistors R₁ to R₄.

As explained hereinabove, according to the present invention, since no bipolar transistors are included therein, it is possible to manufacture the level conversion circuits by using only CMOS technologies. In addition, since use is made of only one power supply voltage, it is possible to adopt a single power supply voltage system. Further, a logic threshold value of the circuit and the duty ratio of the output voltage are hardly affected by the manufacturing fluctuations of the MOS transistors such as the fluctuation of the threshold voltage thereof.

## Claims

1. A level conversion circuit comprising:
first and second power supply terminals (GND, V_{SS});
a MOS differential amplifier (1), connected between said first and second power supply terminals, for receiving first and second input voltages (Vᵢₙ₁, Vᵢₙ₂) to generate first and second complentary output voltages (V₁, V₂) in response to a difference between said first and second input voltages;
a MOS inverter (2), connected to said MOS differential amplifier and between said first and second power supply voltage terminals, for receiving said second complementary output voltage to generate an inverted voltage of said second complementary output voltage; and
a MOS push-pull output circuit (3), connected to said MOS differential amplifier and said MOS inverter and between said first and second power supply voltage terminals, for receiving said first complementary output voltage and said inverted voltage to generate an output voltage (Vₒᵤₜ) in response to said first complementary output voltage and said inverted voltage.

2. The level conversion circuit as set forth in claim 1, wherein one of said first and second input voltages is a reference voltage (V_{ref}).

3. The level conversion circuit as set forth in claim 1, wherein said MOS differential amplifier comprises:
first and second loads (R₁, R₂) connected to said first power supply voltage terminal;
a first MOS transistor (Qₙ₁) of a first conductivity type having a drain connected to said first load, a gate for receiving said first input voltage, and a source;
a second MOS transistor (Qₙ₂) of said first conductivity type having a drain connected to said second load, a gate for receiving said second input voltage, and a source; and
a constant current source (I_{SS}) connected between the sources of said first and second MOS transistors and said second power supply voltage terminal.

4. The level conversion circuit as set forth in claim 3, wherein each of said first and second loads comprises a resistor.

5. The level conversion circuit as set forth in claim 3, wherein said MOS inverter comprises;
a third MOS transistor (Qₚ₁) of a second conductivity type opposite to said first conductivity type having a source connected to said first power supply voltage terminal, a gate for receiving said second complementary output voltage, and a drain for generating said inverted voltage; and
a third load (R₃) connected between the drain of said third MOS transistor and said second power supply voltage terminal.

6. The level conversion circuit as set forth in claim 5, wherein said third load comprises a resistor.

7. The level conversion circuit as set forth in claim 5, wherein said MOS push-pull output circuit comprises:
a fourth MOS transistor (Qₚ₂) of said second conductivity type having a source connected to said first power supply voltage terminal, a gate for receiving said first complementary output voltage, and a drain for generating said output voltage; and
a fifth MOS transistor (Qₙ₃) of said first conductivity type having a drain connected to the drain of said fourth MOS transistor, a gate for receiving said inverted voltage, and a source connected to said second power supply voltage terminal.

8. The level conversion circuit as set forth in claim 3, wherein said constant current source comprises:
a fourth load (R₄) connected to said first power supply voltage terminal;
a sixth MOS transistor (Qₙ₄) of said first conductivity type having a drain connected to the sources of said first and second MOS transistors, a gate connected to said fourth load, and a source connected to said second power supply voltage terminal; and
a seventh MOS transistor (Qₙ₅) of said first conductivity type having a drain connected to said fourth load, a gate connected to said fourth load, and a source connected to said second power supply voltage terminal.

9. The level conversion circuit as set forth in claim 8, wherein said fourth load comprises a resistor.

10. The level conversion circuit as set forth in claim 3, further comprising:
a third power supply voltage terminal (V_{TT});
a fifth resistor (R₅) connected between the gate of said first MOS transistor and said third power supply voltage terminal; and
a sixth resistor (R₆) connected between the gate of said second MOS transistor and said third power supply voltage terminal.

11. The level conversion circuit as set forth in claim 10, wherein each of said fifth and sixth loads comprises a resistor.
